# EUROPEAN PATENT APPLICATION

(11) **EP 0 827 190 A2**
(43) Date of publication of application: **04.03.1998**
(21) Application number: 97113566.0
(22) Date of filing: 24.06.1994
(51) Int. Cl.: H01L 21/60, H01L 23/485

(54) **Bump structure and methods for forming this structure**

(62) Divisional of application: 94109767.7
(71) Applicant: INDUSTRIAL TECHNOLOGY RESEARCH INSTITUTE, Chutung, Hsinchu 31015 (TW)
(72) Inventor: Chang, Shyh-Ming, Hsinchu (TW); Jou, Jwo-Huei, Hsinchu (TW); Lee, Yu-Chi, Sanchung, Taipei Hsien (TW); Hu, Dyi-Chung, Shuang-Shi Tsun, Hsinchu (TW); Yu, Hsiu-Mei, Chutung, Hsinchu Hsien (TW); Yang, Li-Hui, Chutung, Hsinchu Hsien (TW); Chu, Chih-Chiang, Taipei (TW)
(74) Representative: Schmidt-Bogatzky, Jürgen, Dr. Ing.

(57) **Abstract**

A composite bump structure comprising the physical and electrical connections between an integrated circuit element and substrate using a composite bump comprised of a single polymer body of low Young's Modulus and a conductive metal coating. When the bonded structure is formed the composite bump is deformed and the low Young's Modulus of the polymer body allows a very reliable bonded structure with very low bonding force. Due to the low Young's Modulus there is little tendency to separate the connections after the bonded structure is formed. The bond can be formed using thermocompression bonding, ultrasonic bonding, application of heat or application of light. The bond can also be formed using a non conductive adhesive between the integrated circuit element and the substrate. The bond can also be formed with a conductive adhesive coating on the composite bump. The polymer body may be covered by a conductive metal coating formed at the input/output pads of an integrated circuit element or substrate. The composite bump is formed using material deposition, lithography, and etching techniques. A layer of soldering metal can be formed on the composite bumps if this is desired for subsequent processing.

It is possible to use a conductive barrier metal coating covering the polymer body and a soldering metal coating covering the conductive barrier metal coating. When the bonded structure is formed the composite bump is deformed and the low Young's Modulus of the polymer body allows a very reliable bonded structure with very low bonding force. Due to the low Young's Modulus there is little stress tending to break the solder joint after the bonded structure is formed. The bond is formed using a soldering process so that the soldering metal forms a conductive adhesive between the composite bumps and either the substrate input/output pads or the integrated circuit element input/output pads.

## Description

### BACKGROUND OF THE INVENTION

The invention relates to bump structures and methods of forming this structures for the joining of integrated circuit elements to the next level of integration, or that level of integration to the following level, and more particularly to the formation of the bump structures which comprises the physical and electrical connection between the integrated circuit element and the next level of integration.

In the manufacture of highly dense integrated circuits the formation of an inexpensive and highly reliable mechanical bond and electrical interconnection between the integrated circuit element and substrate has long been recognized to be of key importance. Some time ago a solution to this need was patented by L. F. Miller et al in US Pat. No. 3,401,126. This method worked well for many years but increasing levels of integration and circuit density have made the need for interconnections on an increasingly fine pitch of key importance.

A method for achieving increased interconnection density was patented by K. Hatada in US Pat. No. 4,749,120. This method employs a metal bump as the electrical interconnection between the integrated circuit chip and the substrate while holding the integrated circuit chip in place with a resin coating on the substrate acting as an adhesive between chip and substrate. This method has the disadvantage of a relatively high Young's Modulus for metals, especially for gold when compared to that of the resin. As a result of the high Young's Modulus a very large bonding force is required between the integrated circuit chip and the substrate during the micro-bump bonding process while the resin is undergoing its curing cycle. After the bonding process the gold micro-bump will tend to return to its original shape and the recoil forces will disengage some of the micro-bumps from the electrodes on the substrate. Another method patented by Y. Tagusa et al in US Pat. No. 4,963,002 employs nickel plated plastic beads or silver particles to achieve the electrical connection, but the former suffers from small contact surface area and the latter suffers the disadvantage of a relatively high Young's Modulus for silver.

US Pat. No. 4,916,523 issued to Sokolovsky et al shows a unidirectional conductive adhesive to bond the integrated circuit chip to the substrate. US Pat. No. 5,134,460 issued to Brady et al shows conductive metal bumps coated with a gold layer. JP-A-0 544 823 describes that the bumps are formed in the vicnity of a plurality of pad parts.

Furtheron flip chip bonding has been done using several types of bumps. One type simply uses a lead-tin solder or indium alloy solder as the bump which bonds the integrated circuit chip to a substrate. This type of bonding can result in shorting between bumps during solder reflow. Another type of bump uses a copper ball within the lead-tin or indium alloy solder. The copper ball does not melt during solder reflow so there won't be a shorting. However since the copper ball is rigid there can be problems with cracking of joints. Another type of structure is a stack of solder bumps. This type of structure is not easily shorted during reflow and the cracking problem is not present. However, it is difficult to make fine pitch solder reflow joints with this method because of stack misalignment problems.

### SUMMARY OF THE INVENTION

It is the principal object of this invention to provide a composite bump which can be formed on an integrated circuit element, on the substrate to which the integrated circuit element is connected, or on both the integrated circuit element and the substrate. The composite bumps are comprised of a single polymer body with a Young's Modulus which is low compared to metals and a conductive metal coating covering the polymer body. The conductive metal coating covering the polymer body must be chosen to provide good adhesion to the polymer body and may include an adhesive layer and a barrier layer in addition to a conductor layer. The composite bump forms part of the physical and electrical bond between the integrated circuit element and the substrate. The low Young's Modulus of the polymer, between about 0.4 X 10⁶ and 0.5 X 10⁶ psi, allows the bond to be made with very low bonding force, greatly reduces or eliminates the force tending of separate the connections after bonding, and results in extremely reliable physical and electrical connections between the integrated circuit element and substrate.

In accordance to the principal object of the invention to this it is a further object to provide methods of fabrication of the composite bump on either an integrated circuit element or a substrate to which an integrated circuit element can be connected. This object is achieved by depositing a layer of polymer on the surface of an integrated circuit element or substrate. Using photolithographic techniques the polymer is removed everywhere except at the location of the integrated circuit element or substrate input/output pads. Metal is then deposited over the surface of the integrated circuit element or substrate. Using photolithographic techniques the metal is removed everywhere except at the location of the integrated circuit element or substrate input/output pads and the composite bumps are formed. The resulting composite bumps have a single polymer body with a low Young's Modulus relative to metals and a conductive metal coating covering the polymer body. In some instances a metal layer can be formed on the input/output pads and under the polymer body. This metal layer reduces the sheet resistance of the input/output pads. The polymer body must be chosen to withstand the temperatures of subsequent processing such as bonding. The polymer body must also be chosen so that it can be etched during fabrication of the composite bump. Polyamic acid polyimide fulfils these requirements. The conductive metal coating covering the polymer body must be chosen to provide good adhesion to the polymer body and may include an adhesive layer and a barrier layer in addition to a conductor layer.

### BRIEF DESCRIPTION OF DRAWINGS

Fig. 1A shows a cross sectional view of a composite bump formed on an integrated circuit element or substrate.

Fig. 1B shows a cross sectional view of a composite bump formed on an integrated circuit element or substrate with a solder coating on the composite bump.

Fig. 2 shows a cross sectional view of a composite bump formed in a hemispherical shape on an integrated circuit element or substrate.

Fig. 3 shows a cross sectional view of a composite bump formed with a rough shape on an integrated circuit element or substrate.

Fig. 4 shows a cross sectional view of composite bumps formed so that there are multiple bumps within the input/output pattern of an integrated circuit element or substrate.

Fig. 5 shows a cross sectional view of composite bumps formed so that there are multiple bumps within and extending beyond the input/output pattern of an integrated circuit element or substrate.

Fig. 6 shows a cross sectional view of composite bumps formed so that there are multiple bumps forming a ring around the input/output pattern of an integrated circuit element or substrate.

Figs. 7A through 7I show cross sectional representations of the method for forming composite bumps using photoresist for pattering the polymer and metal layers.

Figs. 8A through 8J show cross sectional representations of the method for forming composite bumps with a base metal layer under the composite and on top of the input/output pad using photoresist for patterning the polymer and metal layers.

Figs. 9A through 9G show cross sectional representations of the method for forming composite bumps using photosensitive polymer to pattern the polymer layer and photoresist to pattern the metal layer.

Figs. 10A through 10H show cross sectional representations of the method for forming composite bumps with a base metal layer under the composite bump and on top of the input/output pad using photosensitive polymer to pattern the polymer layer and photoresist to pattern the metal layer.

Figs. 11A through 11E show cross sectional representations of the method for forming composite bumps using a lift off process.

Figs. 12A through 12C show cross sectional representations of the method for forming a solder layer on the composite bumps.

Fig. 13 is a cross sectional representation of composite bumps with a solder layer formed on the integrated circuit element input/output pads before soldering.

Fig. 14 is a cross sectional representation of structure after soldering where the composite bumps and the solder layer were formed on the integrated circuit element input/output pads prior to soldering.

Fig. 15 is a cross sectional representation of composite bumps with a solder layer formed on the substrate input/output pads before soldering.

Fig. 16 is a cross sectional representation of structure after soldering where the composite bumps and the solder layer were formed on the substrate input/output pads prior to soldering.

Fig. 17 is a cross sectional representation of composite bumps formed on the integrated circuit element input/output pads and a solder layer formed on the substrate input/output pads prior to soldering.

Fig. 18 is a cross sectional representation of the structure after soldering where composite bumps were formed on the integrated circuit element input/output pads and the solder was formed on the substrate input/output pads prior to soldering.

Fig. 19 is a cross sectional representation of composite bumps formed on the substrate input/output pads and a solder layer formed on the integrated circuit element input/output pads prior to soldering.

Fig. 20 is a cross sectional representation of the structure after soldering where composite bumps were formed on the substrate input/output pads and the solder was formed on the integrated circuit element input/output pads prior to soldering.

### DESCRIPTION OF THE PREFERRED EMBODIMENTS

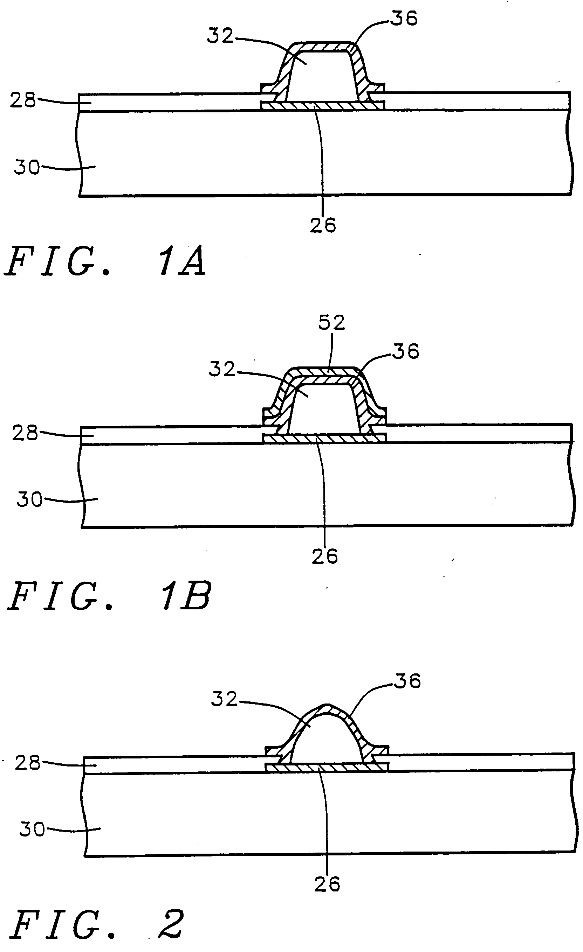

Fig. 1A shows an embodiment of the composite bump formed on either an integrated circuit element or on a substrate. A passivation layer 28 and an aluminium input/output pad 26 of about 90 microns diameter is formed on an integrated circuit element or substrate 30. A polymer body 32 with a thickness of between about 5 microns and 25 microns is formed on the input/output pad 26. The polymer body can be polyamic acid polyimide such as PROBIMIDE 7010 or PROBIMIDE 514 produced by OCG Microelectronic Materials, Inc., Tempe, AZ.

A conductive metal coating 36 is formed over the polymer body and must adhere to the polymer body. The coating can be a metal such as aluminium or nickel; or a composite such as nickel/gold, chrome/gold, chrome/silver, or titanium/platinum. The conductive metal coating 36 can be a composite which includes an adhesion layer/a barrier layer/ a conductor layer such as chrome/copper/gold, chrome/nickel/gold, chrome/silver/gold, titanium/platinum/gold gold, titanium/palladium/gold, or titanium/tungsten/gold. A solder coating, such as PbSn, InGa, or InSn may be formed over the conductive metal coating, shown in Fig. 1B, if this is desired for a soldering process. In this case the preferred conductive metal coatings are chrome/copper/gold, chrome/nickel/gold, chrome/silver/gold, titanium/platinum/gold, or titanium/palladium/gold.

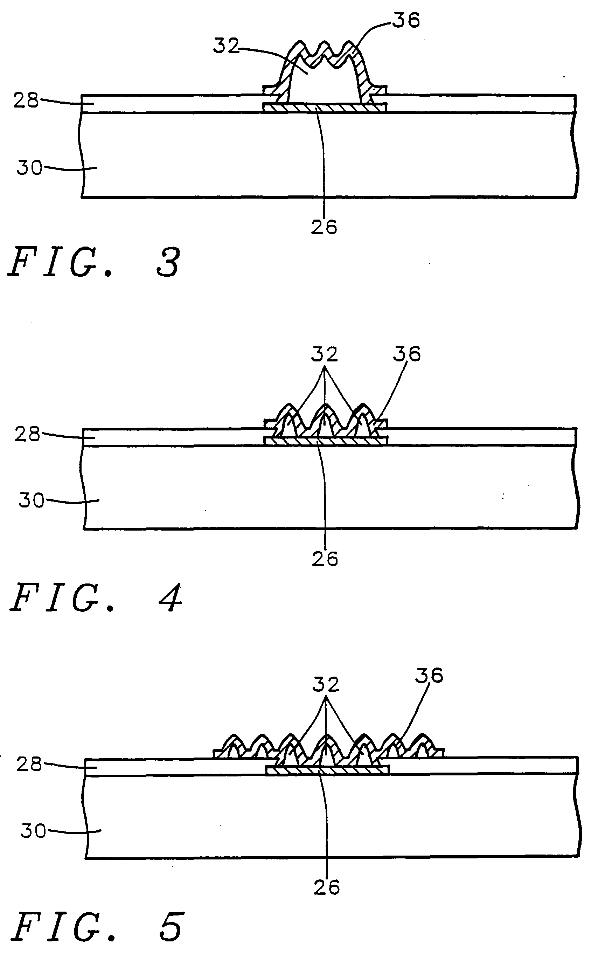

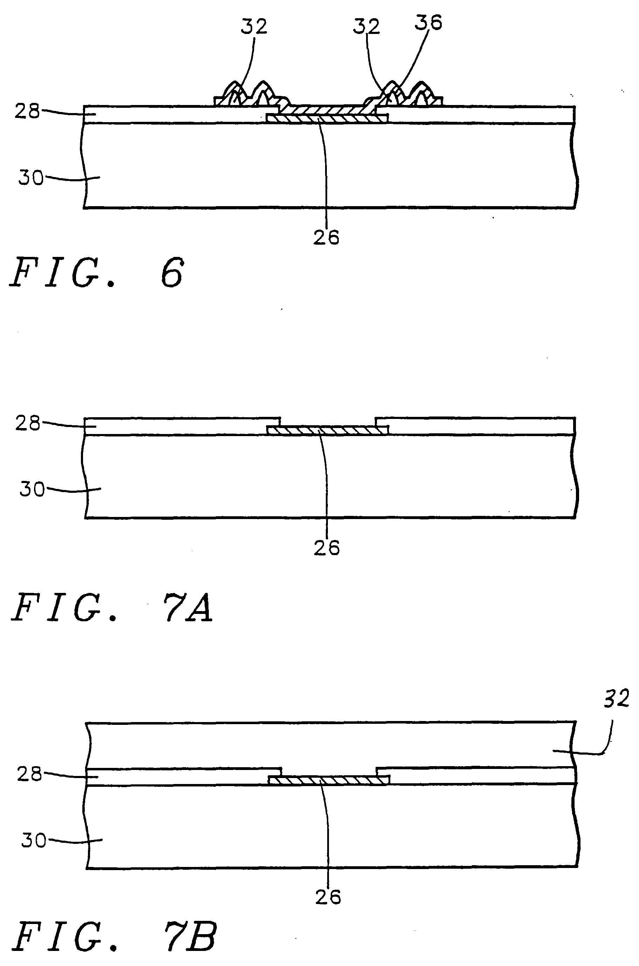

Additional embodiments of the composite bump are shown in Fig. 2 through Fig. 6. Fig. 2 shows a composite bump formed in a hemispherical shape. Fig. 3 shows a composite bump formed with a rough surface on the bump. Fig. 4 shows multiple composite bumps formed inside the input/output pattern 26 of the integrated circuit element or substrate 30. Fig. 5 shows multiple composite bumps formed both inside and in a ring surrounding the input/output pattern 26 of the integrated circuit element or substrate 30. Fig. 6 shows multiple composite bumps formed in a ring surrounding the input/output pattern 26 of the integrated circuit element or substrate 30.

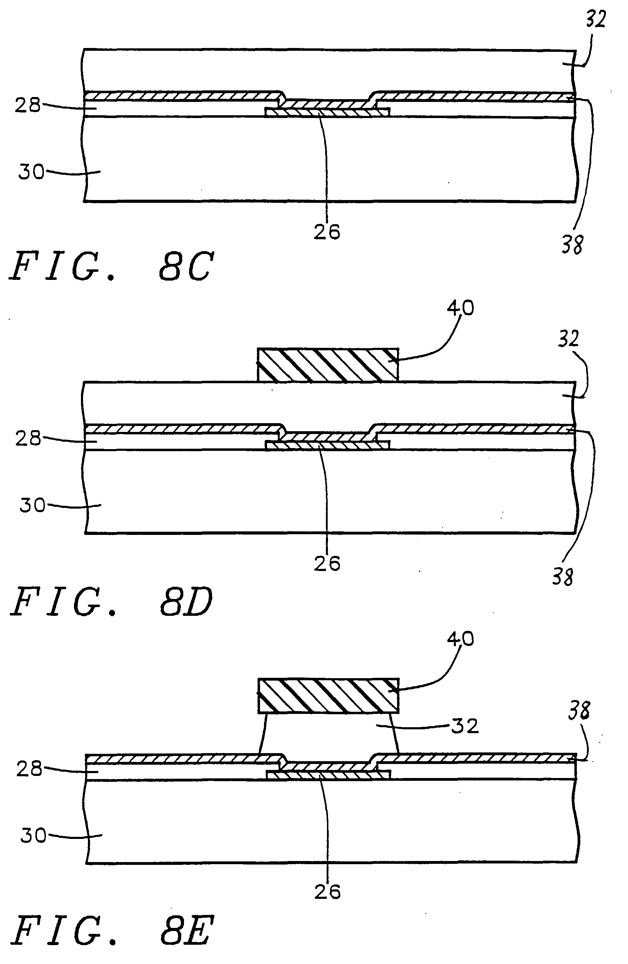

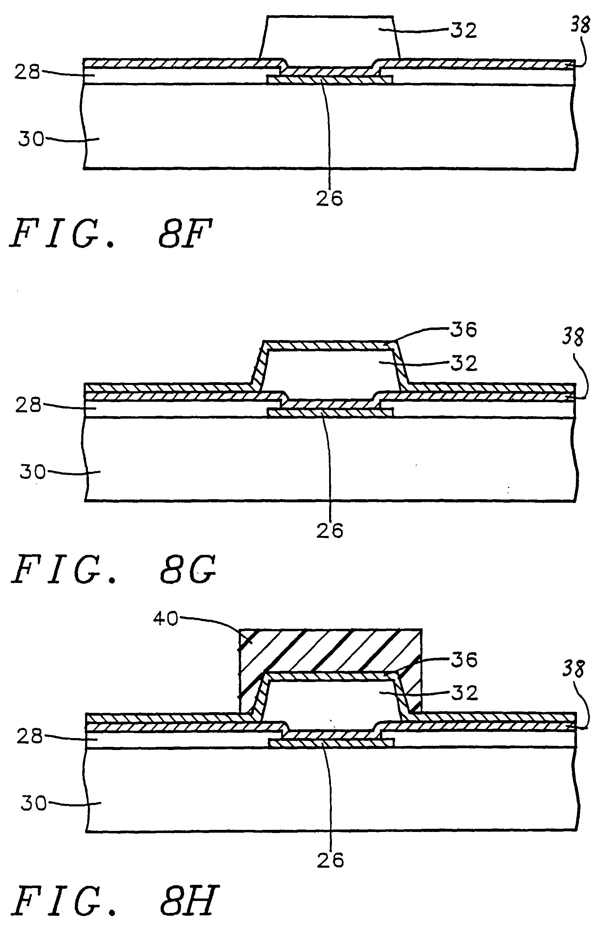

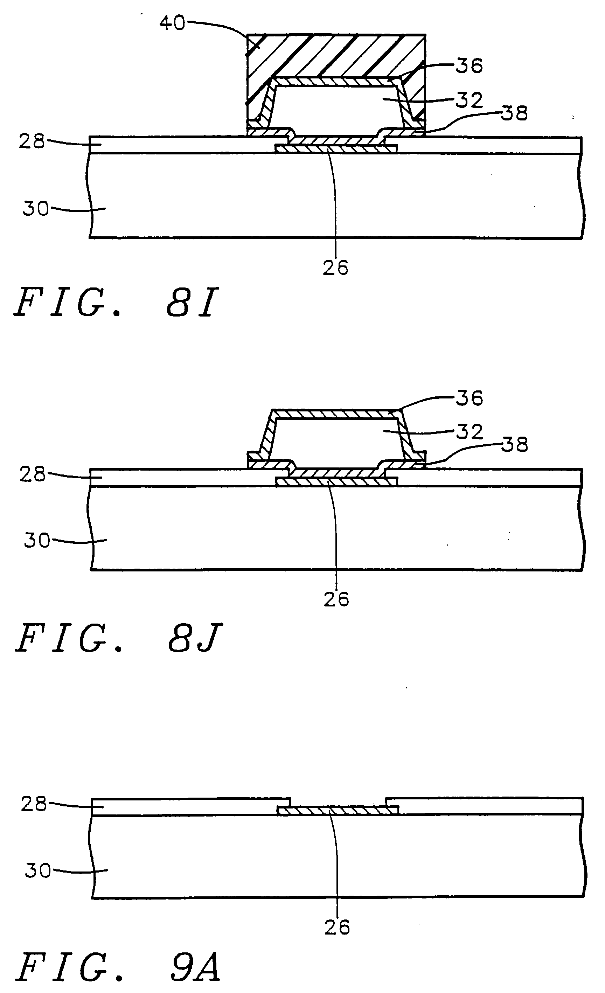

The above embodiments may also have a base metal layer of aluminium 38 formed under the polymer body 32 and on top of the input/output pad 26 as shown in Fig. 8J. This base metal layer extends over the edges of the passivation layer 28.

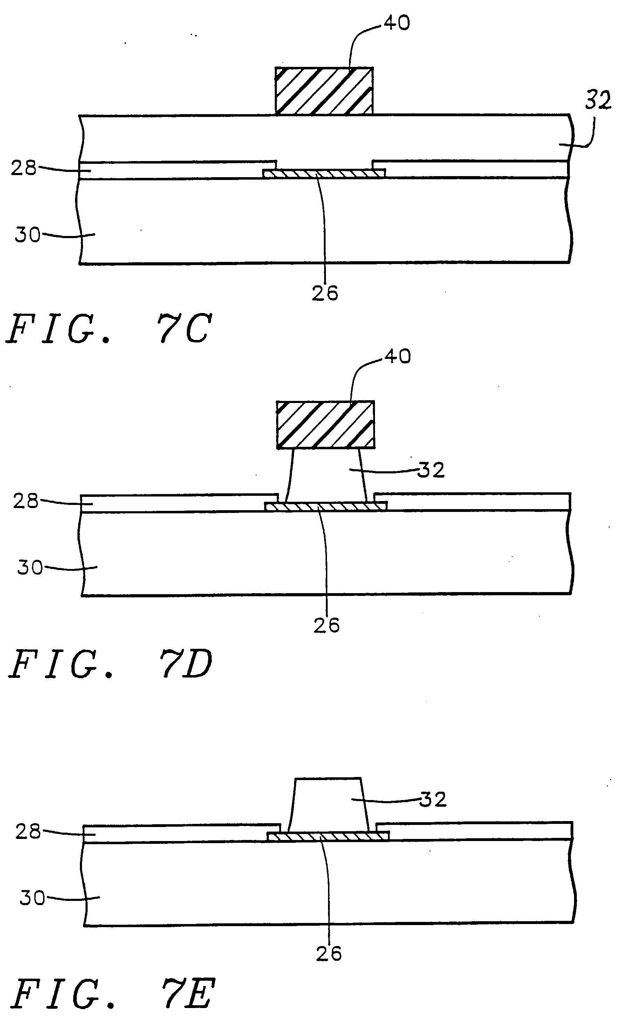

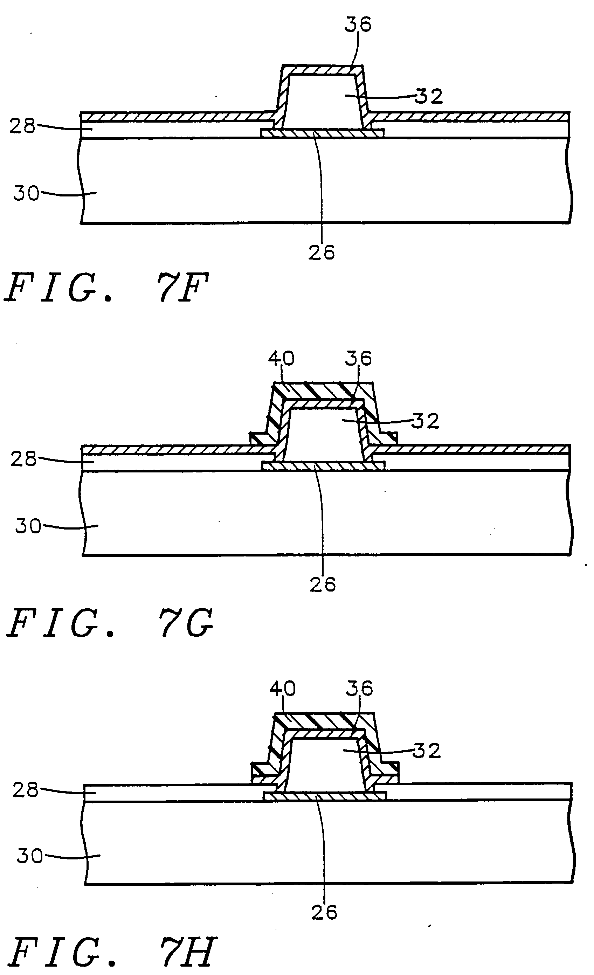

Refer now more particularly to Figs. 7A through 7I. There is shown an embodiment of a method for forming the composite bump of the current invention. First the integrated circuit element or substrate 30 with a passivation layer 28 and aluminium input/output pads 26 with a diameter of about 90 microns is etched and cleaned, as shown in Fig. 7A. Next, as shown in Fig. 7B, a layer of non-photosensitive polymer 32 such as a polyamic acid polyimide like PROBIMIDE 514 produced by OCG Microelectronic Materials, Inc., Tempe, AZ. with a thickness of between about 5 and 25 microns is formed on the surface of the integrated circuit element or substrate 30. Next, as shown in Fig. 7C, a photoresist pattern 40 is formed on the polyamic acid polyimide. As shown in Fig. 7D, the polyamic acid polyimide is then etched to the photoresist pattern using MF-319 at room temperature for between about 1 and 3 minutes. Patterning of polyimide films is described in Chapter 8 of POLYIMIDES edited by Wilson, Stenzenberger, and Hergenrother published by Blackie & Son Ltd. in 1990. The photoresist is then stripped, Fig. 7E. As shown in Fig. 7F a conductive metal layer 36 such as a composite of chrome/gold with chrome about 500 Angstroms thick and gold about 2000 Angstroms thick is deposited on the integrated circuit element or substrate 30. The coating 36 can also be a metal such as aluminium or nickel; or a composite such as nickel/gold, chrome/silver, or titanium/platinum. The conductive metal coating 36 can also be a composite which includes an adhesion layer/ a barrier layer/ a conductor layer such as chrome/copper/gold, chrome/nickel/gold, chrome/silver/gold, titanium/platinum/gold, titanium/palladium/gold, or titanium/tungsten/gold.

A patterned layer of photoresist 40, Fig. 7G, is then formed on the conductive metal layer 36 and the conductive metal layer is etched to the pattern, of the photoresist 40, Fig. 7H. The photoresist is then stripped, Fig. 7I, and the composite bump is formed. For the chrome/gold conductive metal layer etching can be accomplished using 1g Ce (SO₄) ₂*2(NH₄)₂SO₄*2H₂0 + 5ml HNO₃ + 25ml H₂O at 28°C to etch chrome at about 85 Angstroms/minute and 4g KI + 1g I₂ + 40ml H₂O at room temperature to etch gold at between about 0.5 and 1.0 microns/minute.

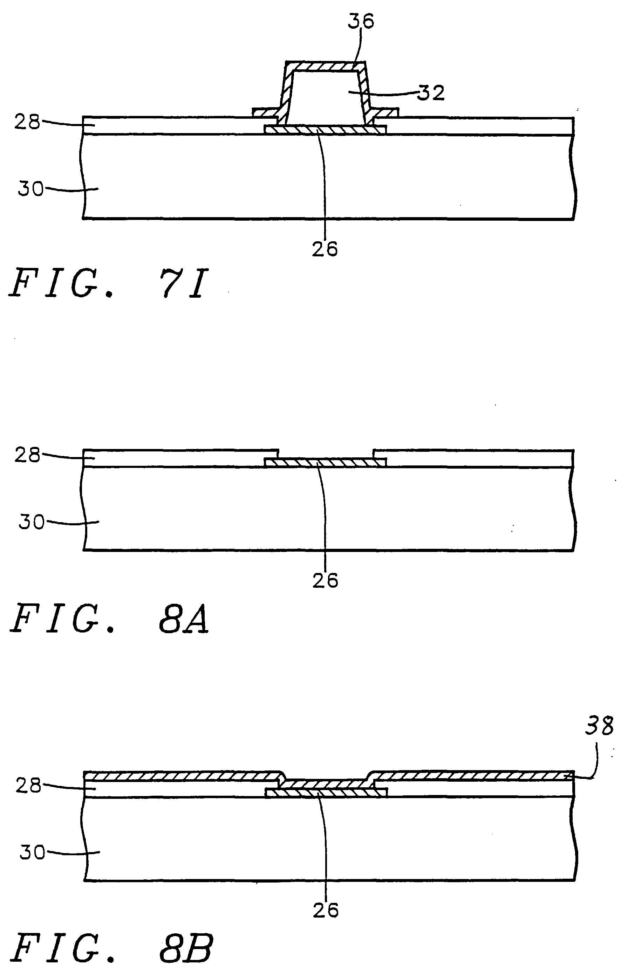

Another embodiment method is shown in Figs. 8A through 8J. The integrated circuit element or substrate 30 with a passivation layer 28 and aluminum input/output pads 26 with a diameter of about 90 microns is etched and cleaned, as shown in Fig. 8A. Next, as shown in Fig. 8B, a layer of metal 38 such as aluminium is deposited on the integrated circuit element or substrate 30. The method then proceeds as described in the immediately preceding embodiment beginning with the formation of the layer of polyamic acid polyimide 32 and continuing until the conductive metal coating 36 is etched, Figs. 8C to 8I. The layer of metal 38 such as aluminum is then etched using H₃PO₄: CH₃COOH:HNO₃:H₂O (4:4:1:1) at room temperature at about 350 Angstroms/minute. As shown in Fig. 8J the photoresist is then stripped and the composite bump is formed.

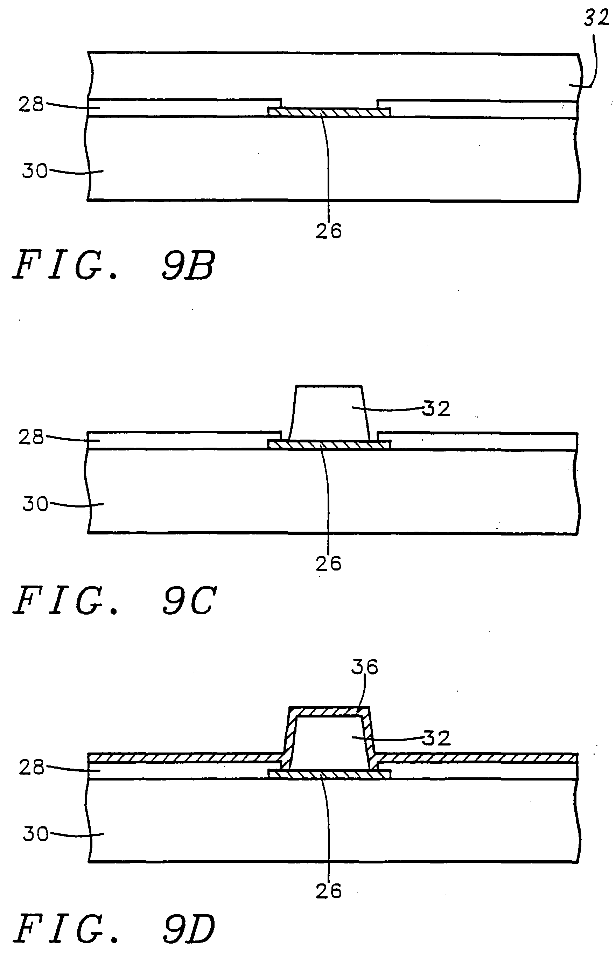

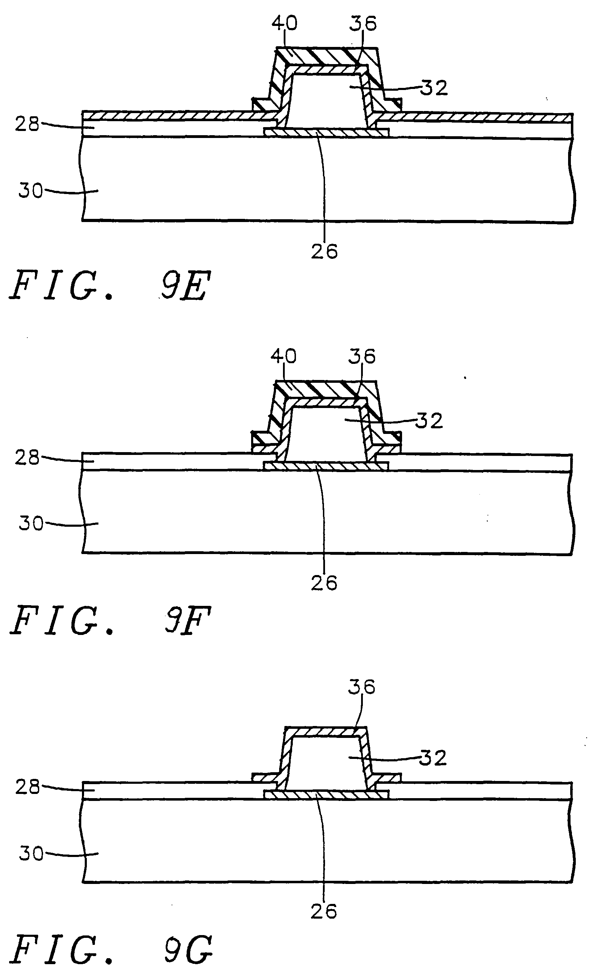

Another embodiment method is shown in Figs. 9A through 9G. After the integrated circuit element or substrate 30 with input/output pads of about 90 microns diameter is etched and cleaned, Fig. 9A, a layer of photosensitive polymer 32 such as photosensitive polyamic acid polyimide, like PROBIMIDE 7020 produced by OCG Microelectronic Materials, Inc., Tempe, AZ. with a thickness of between about 5 and 25 microns is formed on the surface integrated circuit element or substrate 30, Fig. 9B. The photosensitive polymer 32 is exposed and developed leaving polymer 32 only over the input/output pads, Fig. 9C. Patterning of polyimide films is described in Chapter 8 of POLYIMIDES edited by Wilson, Stenzenberger, and Hergenrother published by Blackie & Son Ltd. in 1990. Next a conductive metal layer 26 such as a composite of chrome/gold is deposited on the integrated circuit element or substrate 30 as shown in Fig. 9D and the process proceeds as described in the previous embodiment, Figs. 9E, 9F, and 9G.

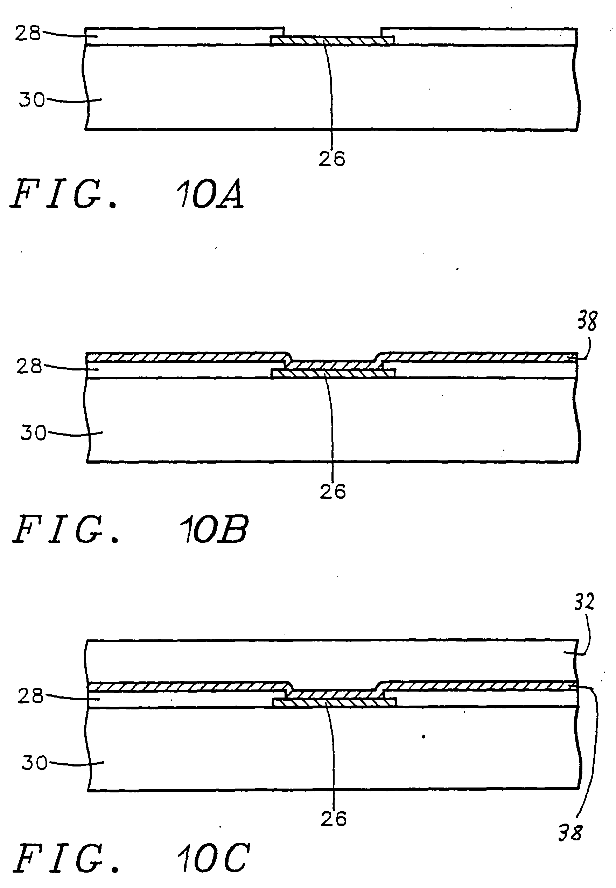

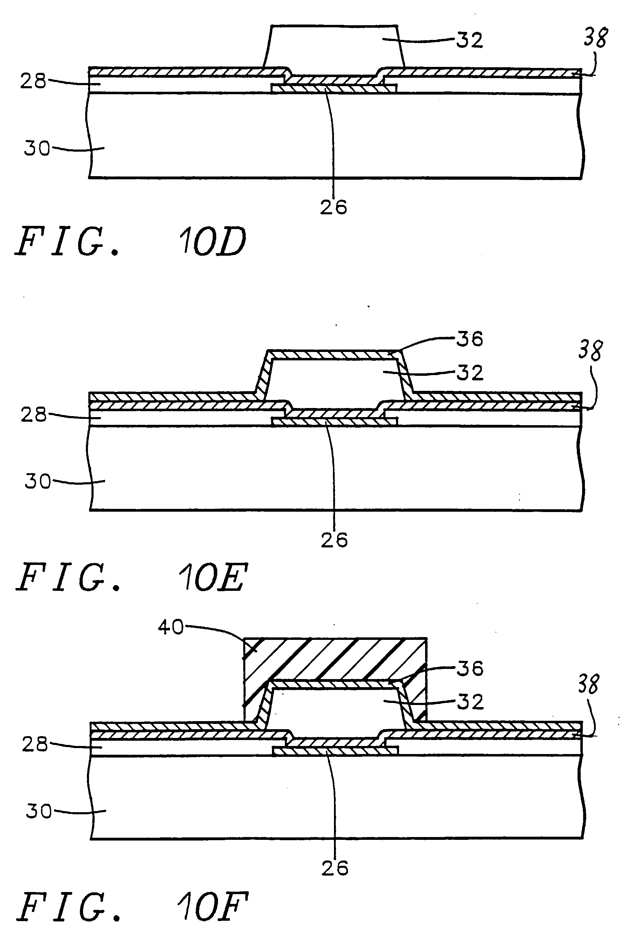

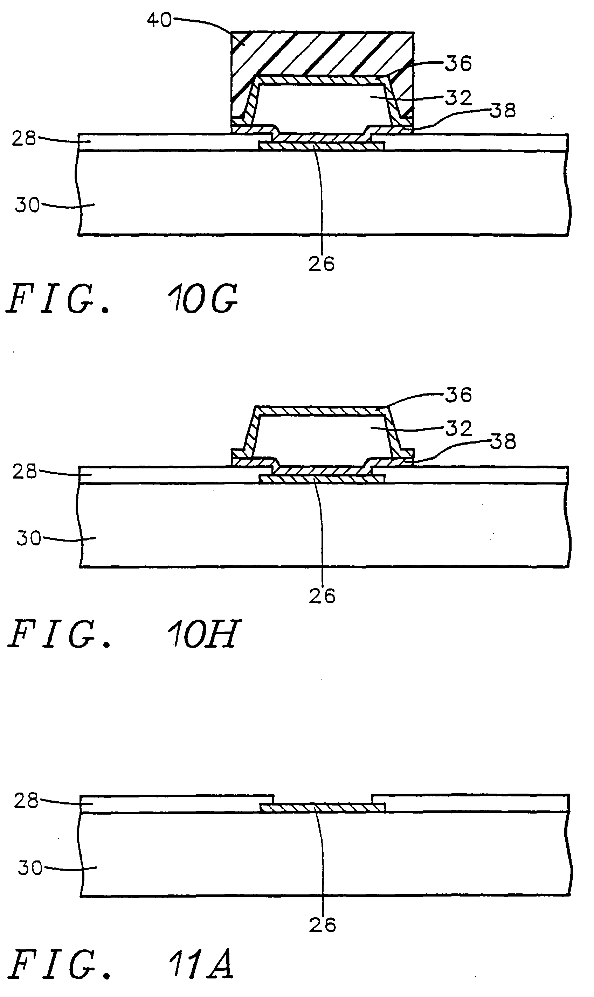

Another embodiment method is shown in Figs. 10A through 10J. The integrated circuit element or substrate 30 with a passivation layer 28 and aluminium input/output pads 26 with a diameter of about 90 microns is etched and cleaned, as shown in Fig. 10A. Next, as shown in Fig. 10B, a layer of metal 38 such as aluminium is deposited on the integrated circuit element or substrate 30. The method then proceeds as described in the immediately preceding embodiment beginning with the formation of the layer of photosensitive polyamic acid polyimide 32 and continuing until the conductive metal coating 36 is etched, Figs. 10C to 10G. The layer of metal 38 such as aluminium is then etched using H₃PO₄:CH₃COOH:HNO₃:H₂O (4:4:1:1) at room temperature at about 350 Angstroms/minute. As shown in Fig. 10H the photoresist is then stripped and the composite bump is formed.

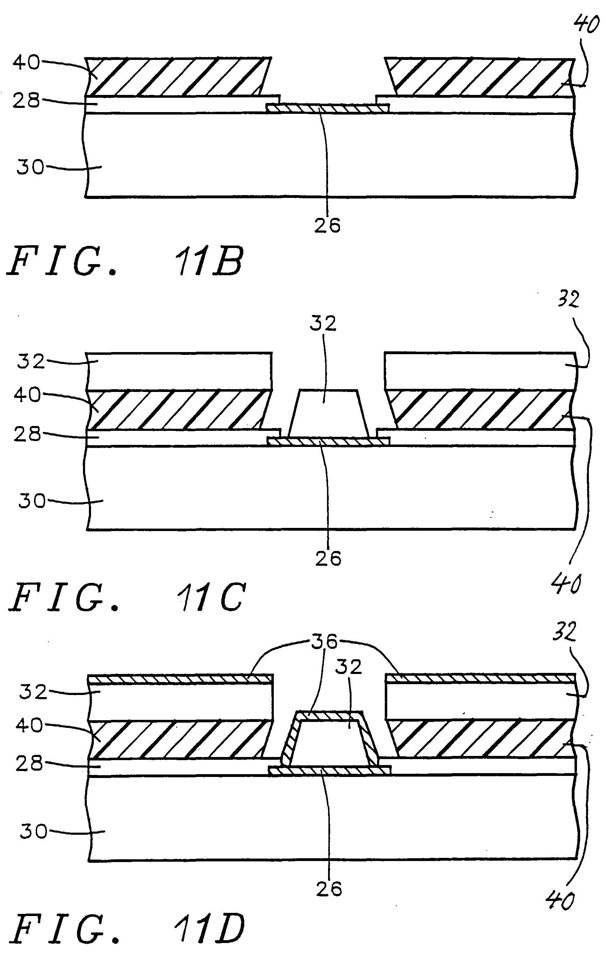

Another embodiment is shown in Figs. 11A through 11E. First the integrated circuit element or substrate 30 with about 90 micron diameter input/output pads 26 is etched and cleaned, Fig. 11A. Next a photo resist mask 40 is formed leaving photoresist everywhere except over the input/output pads 26, Fig. 11B. Next a layer of polymer 32 is formed on the integrated circuit element of substrate 30 using vapor deposition polymerization. In a vacuum of about 3.75 X 10⁻⁵ Torr 4,4 Oxy-Dianiline (ODA) is sprayed onto the integrated circuit element or wafer and heated to between about 80°C and 160°C. While still at 3.75 X 10⁻⁵ Torr pyromellitic dianhydride (PMDA) is sprayed onto the integrated circuit element or wafer and heated to between about 130°C and 180°C. Vapor deposition polymerization is described by Takahashi et al in MACROMOLECULES, Vol. 24, No. 12, 1991, pp. 3543-3546. Next, as shown in Fig. 11D, a conductive metal layer 36 such as a composite of chrome/gold with chrome about 500 Angstroms thick and gold about 2000 Angstroms thick is deposited on the integrated circuit element or substrate 30. The coating 36 can also be the same metals described in the previous embodiments. Then the photoresist mask 40 is removed thereby removing the polymer and metal deposited on the photoresist leaving the composite bump, Fig. 11E.

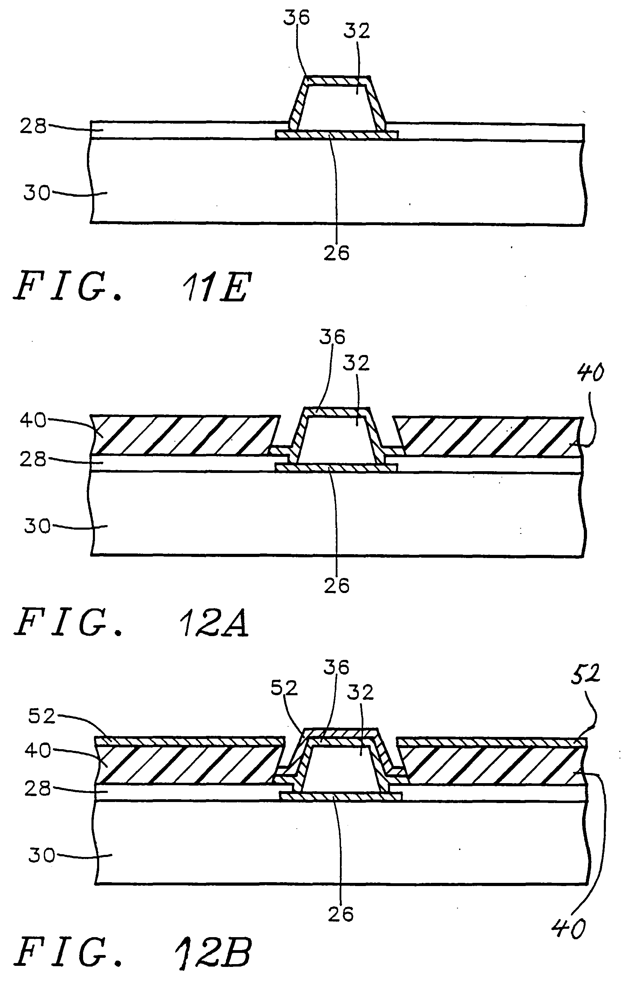

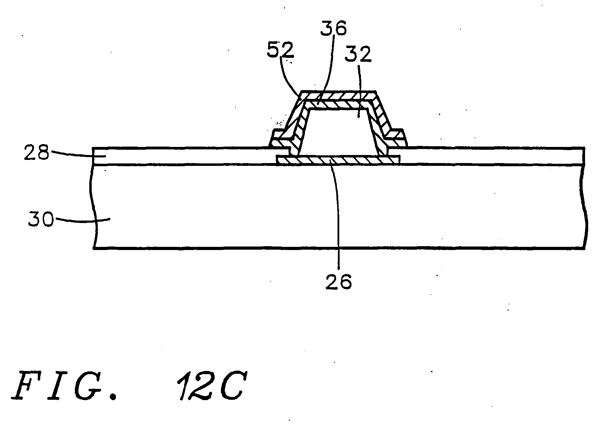

Another embodiment when a solder coating is desired on the composite bump is shown in Figs. 12A through 12C. Composite bumps are formed on the integrated circuit element or substrate 30 using any of the preceding embodiment methods. In this case the preferred conductive metal coatings are chrome/copper/gold, chrome/nickel/gold, chrome/silver/gold, titanium/platinum/gold, or titanium/palladium/gold. A layer of photoresist 40 is then formed on the surface of the integrated circuit element or substrate 30 and patterned so that only the composite bumps are exposed, Fig. 12A. Solder 52, preferably 95% lead 5% tin is then deposited using chemical vapor deposition, Fig. 12B. Other percentages of lead and tin or solders using indium-tin or indium-gallium can also be used. The photoresist is then stripped thereby also removing the solder everywhere except on the composite bumps, Fig. 12C.

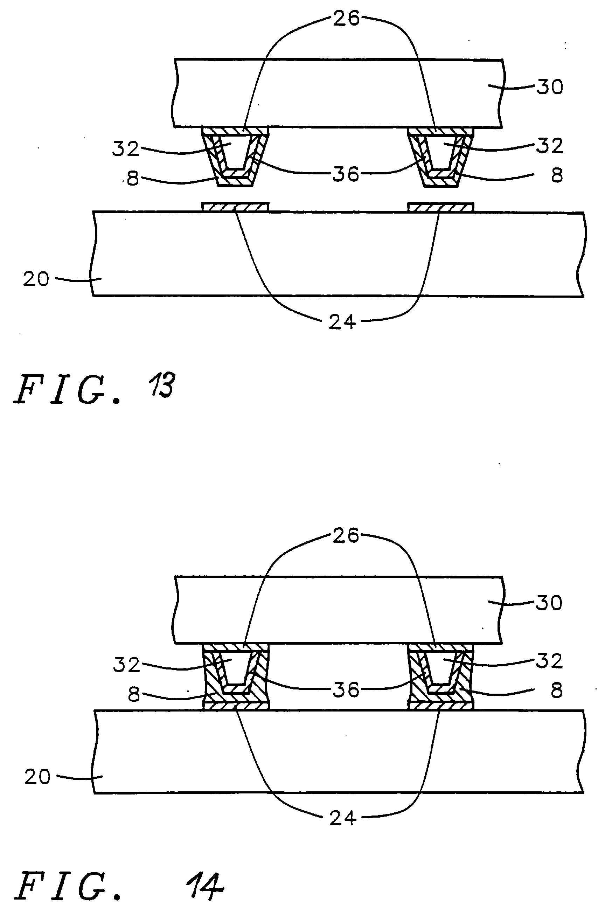

Refer now more particularly to Figs. 13 and 14, there is shown an embodiment for the bonded structure of the current invention. As shown in Fig. 13 composite bumps are formed on the integrated circuit element input/output pads 26 which are a metal such as aluminium about 90 microns in diameter. Each composite bump is composed of a polymer body 32 such as polyamic acid polyimide with a thickness between about 5 and 25 microns, a conductive metal coating 36 covering the polymer body, and a soldering metal coating 8 covering the conductive metal coating. The conductive metal coating must adhere to the polymer body and can be a composite such as chrome/copper/gold, chrome/nickel/gold, chrome/silver/gold, titanium/tungsten/gold, titanium/platinum/gold, or titanium/palladium/gold. For chrome/copper/gold the thickness can be about 500 Angstroms chrome/500 Angstroms copper/2000 Angstroms gold. The soldering metal layer can be metal alloys such as lead-tin, indium-gallium, or indium-tin. For lead-tin the soldering metal layer can be 95% lead-5% tin with a thickness of between about 1 and 20 microns. Substrate input/output pads 24 are formed on the substrate 20 and are formed from a metal the solder will wet such as chrome/copper/gold or other metal composites used for the conductive metal coating on the polymer body of the composite bump. Fig. 14 shows the bonded structure after soldering. The soldering metal 8 bonds the composite bump structure to the substrate input/output pads 24.

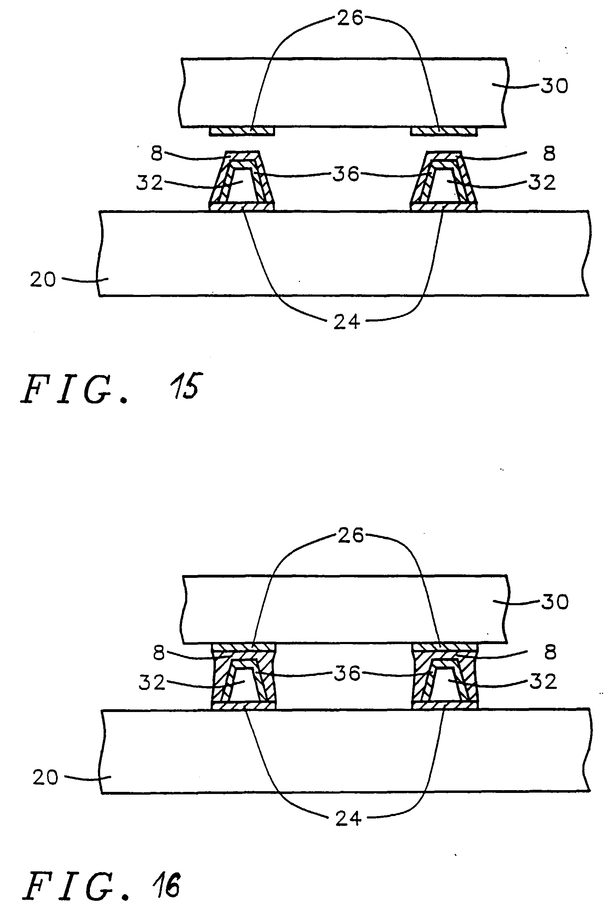

Figs. 15 and 16 show another embodiment of the bonded structure. As shown in Fig. 15 the composite bumps are formed on the substrate 20 input/output pads 24 which are a metal such as aluminium about 90 microns in diameter. Each composite bump is composed of a polymer body 32 such as polyamic acid polyimide with a thickness between about 5 and 25 microns, a conductive metal coating 36 covering the polymer body, and a soldering metal coating 8 covering the conductive metal coating. The conductive metal coating must adhere to the polymer body and can be a composite such as chrome/copper/gold, chrome/nickel/gold, chrome/silver/gold, titanium/tungsten/gold, titanium platinum/gold, or titanium/palladium/gold. For chrome/copper/gold the thickness can be about 500 Angstroms chrome/500 Angstroms copper/2000 Angstroms gold. The soldering metal layer can be metal alloys such as lead-tin, indium-gallium, or indium-tin. For lead-tin the soldering metal layer can be 95% lead-5% tin with a thickness of between about 1 and 20 microns. Integrated circuit element input/output pads 26 are formed on the integrated circuit element 30 and are formed a metal the solder will wet such as chrome/copper gold or other metal composites used for the conductive metal coating on the polymer body of the composite bump. Fig. 16 shows the bonded structure after soldering. The soldering metal 8 bonds the composite bump structure to the integrated circuit element input/output pads 26.

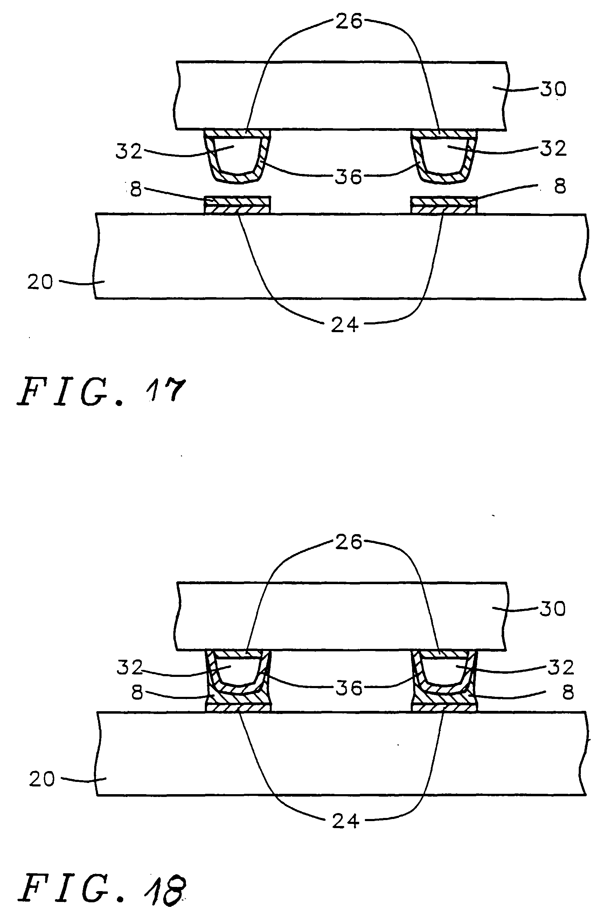

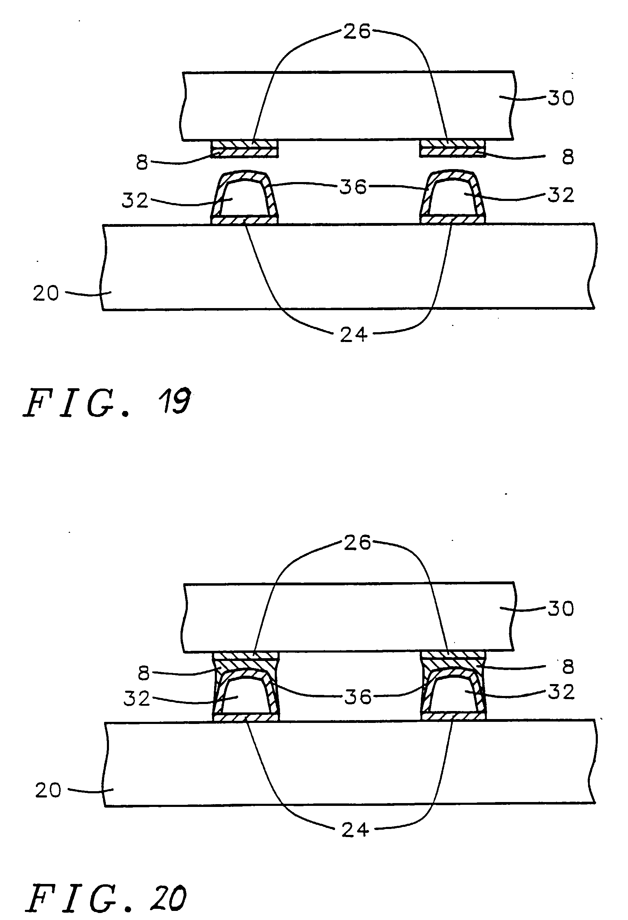

Figs. 17 and 18 show another embodiment of the bonded structure. As shown in Fig. 17 the composite bumps are formed on the integrated circuit element input/output pads 26 which are a metal such as aluminium about 90 microns in diameter. Each composite bump is composed of a polymer body 32 such as polyamic acid polyimide with a thickness between about 5 and 25 microns and a conductive metal coating 36 covering the polymer body. The conductive metal coating must adhere to the polymer body and can be a composite such as chrome/copper/gold, chrome/nickel/gold, chrome/silver/gold, titanium/tungsten/gold, titanium/platinum/gold, or titanium/palladium/gold. For chrome/copper/gold the thickness can be about 500 Angstroms chrome/500 Angstroms copper/2000 Angstroms gold. The soldering metal 8 is formed on the substrate 20 input/output pads 24 which must be a metal wettable by the solder, for example copper, chrome/copper/gold. The soldering metal can be 95% lead-5% tin, other alloys of lead-tin, alloys of indium-gallium, or alloys of indium-tin. Fig. 18 shows the bonded structure after soldering. The soldering metal 8 bonds the composite bump structure to the substrate input/output pads 24.

Figs. 19 and 20 show another embodiment of the bonded structure. As shown in Fig. 19 the composite bumps are formed on the substrate 20 input/output pads 24 which are metal such as aluminium and about 90 microns in diameter. Each composite bump is composed of a polymer body 32 such as polyamic acid polyimide with a thickness between about 5 and 25 microns and a conductive metal coating 36 covering the polymer body. The conductive metal coating must adhere to the polymer body and can be a composite such as chrome/copper/gold, chrome/nickel/gold, chrome/silver/gold, titanium/tungsten/gold, titanium/platinum/gold, or titanium/palladium/gold. For chrome/copper/gold the thickness can be about 500 Angstroms chrome/500 Angstroms copper/2000 Angstroms gold. The soldering metal 8 is formed on the integrated circuit element 30 input/output pads 26 which must be a metal wettable by the solder, for example chrome/copper/gold or other composites used as the conductive metal coating covering the polymer body. The soldering metal can be 95% lead-5% tin, other alloys of lead-tin, alloys of indium-gallium, or alloys of indium-tin. Fig. 20 shows the bonded structure after soldering. The soldering metal 8 bonds the composite bump structure to the integrated circuit element input/output pads 26.

Figs. 13 and 14 show an embodiment of a method of forming the bonded structure of the current invention. As shown in Fig. 13 composite bumps are formed on the integrated circuit element input/output pads 26 which are a metal such as aluminum. Each composite bump is composed of a polymer body 32 such as polyamic acid polyimide, a conductive metal coating 36 covering the polymer body, and a coating of soldering metal 8 covering the conductive metal coating. The conductive metal coating must adhere to the polymer body and can be a composite such as chrome/copper/gold, chrome/nickel/gold, chrome/silver/gold, titanium/tungsten/gold, titanium/platinum/gold, or titanium/palladium/gold. For chrome/copper gold the thickness can be about 500 Angstroms chrome/500 Angstroms copper/2000 Angstroms gold. The soldering metal layer 38 can be metal alloys such as lead-tin, indium-gallium, or indium-tin. For lead-tin the soldering metal layer can be 95% lead-5% tin with a thickness of between about 1 and 20 microns. Substrate input/output pads 24 are formed on the substrate 20 and are formed from a metal the solder will wet such chrome/copper/gold or other metal composites used for the conductive metal coating on the polymer body of the composite bump.

The integrated circuit element 30 and the substrate 20 are then brought together so that the composite bumps are brought together with the substrate input/output pads 24. Heat is applied to the soldering metal 8 thereby raising its temperature to about 30°C above the melting point of the soldering metal used. For the 95% lead-5% tin solder alloy the temperature is raised to about 350°C. The soldering metal melts wetting the substrate input/output pads 24, the heat is removed, and as the solder cools below the melting point the bonded structure is formed. Due to the low Young's Modulus of the polymer body the stress tending to break the solder joint during or after the soldering process is extremely small.

Figs. 15 and 16 show another embodiment of a method of forming the bonded structure. As shown in Fig. 15 the composite bump is formed on the substrate 20 input/output pad 24 prior to bonding. The composite bump includes a polymer body 32, a conductive metal coating 36, and a coating of soldering metal 8 such as alloys of lead-tin, indium-gallium, or indium-tin. The integrated circuit element 30 input/output pad 26 is formed from a metal wettable by the solder used.

The integrated circuit element 30 and the substrate 20 are then brought together so that the composite bumps are brought together with the integrated circuit element 30 input/output pads 24. Heat is applied to the soldering metal 8 thereby raising its temperature to about 30°C above the melting point of the soldering metal used. For the 95% lead-5% tin solder alloy the temperature is raised to about 350°C. The soldering metal melts wetting the integrated circuit element input/output pads 26, the heat is removed, and as the solder cools below the melting point the bonded structure is formed. Due to the low Young's Modulus of the polymer body the stress tending to break the solder joints during or after the soldering process is extremely small.

Figs. 17 and 18 show another embodiment of a method of forming the bonded structure. As shown in Fig. 17 the composite bump is formed on the integrated circuit element 30 input/output pads 26 prior to bonding. The composite bump includes a polymer body 32 and a conductive metal coating 36. A soldering metal coating 8, such as alloys of lead-tin, indium-gallium, or indium-tin, is formed on the substrate 20 input/output pads 24. The substrate 20 input/output pads 24 are formed from a metal wettable by the solder used. The integrated circuit element 30 and the substrate 20 are then brought together so that the composite bumps are brought together with the substrate 20 input/output pads 24. The soldering process then proceeds as described in the previous embodiments.

Figs. 19 and 20 show another embodiment of a method of forming the bonded structure. As shown in Fig. 19 the composite bump is formed on the substrate 20 input/output pads 24 prior to bonding. The composite bump includes a polymer body 32 and a conductive metal coating 36. A coating of soldering metal 8, such as alloys of lead-tin, indium-gallium, or indium-tin, is formed on the integrated circuit element 30 input/output pads 26. The integrated circuit element 30 input/output pads 26 are formed from a metal wettable by the solder used. The integrated circuit element 30 and the substrate 20 are then brought together so that the composite bumps are brought together with the integrated circuit element 30 input/output pads 26. The soldering process then proceeds as described in the previous embodiments.

While the invention has been particularly shown and described with reference to the preferred embodiments thereof, it will be understood by those skilled in the art that various changes in form and details may be made without departing from the spirit and scope of the invention.

## Claims

1. A method of forming a composite bump structure by joining of integrated circuit elements to the next level of integration or that level of integration to the following level according to claims 9 to 16, for forming composite bumps comprising the steps of:
providing an integrated circuit element or substrate with input/output pads;
forming a polymer layer on the surface of said integrated circuit element or substrate;
forming a first photoresist mask on said polymer layer directly over said input/output pads;
etching said polymer not protected by first photoresist mask;
stripping said first photoresist mask;
forming a conductive metal layer over the surface of said integrated circuit element or substrate;
forming a second photoresist mask on said conductive metal layer directly over said input/output pads;
etching said conductive metal not protected by said second photoresist mask; and
stripping said second photoresist mask.

2. A method of forming a composite bump structure by joining of integrated circuit elements to the next level of integration or that level of integration to the following level for forming composite bumps comprising the steps of:
providing an integrated circuit element or substrate with input/output pads;
forming a first photoresist mask by lithography over said integrated circuit element or substrate surface except those areas directly over said input/output pads;
forming a layer of non-photosensitive polymer over the surface of said integrated circuit element or substrate using vapor deposition polymerization;
forming a conductive metal layer over said integrated circuit element or substrate; and
removing said first photoresist mask thereby removing said non-photosensitive polymer and said conductive metal over said photoresist mask, leaving said non-photosensitive polymer and said conductive metal over said input/output pads.

3. A method of forming a composite bump structure by joining of integrated circuit elements to the next level of integration, or that level of integration to the following level comprising the steps of:
providing an integrated circuit element with input/output pads and composite bumps comprised of a single polymer body and a conductive metal coating covering said polymer body formed on said integrated circuit element input/output pads;
providing a substrate with input/output pads;
providing a soldering metal;
bringing together said composite bumps formed on said integrated circuit element input/output pads, said substrate input/output pads, and said soldering metal;
heating said soldering metal to a temperature of about 30°C above the melting point of said soldering metal; and cooling said soldering metal below the melting point of said soldering metal.

4. A method of forming a composite bump structure by joining of integrated circuit elements to the next level of integration, or that level of integration to the following level comprising the steps of:
providing a substrate with input/output pads and composite bumps comprised of a single polymer body and a conductive metal coating covering said polymer body formed on said substrate input/output pads;
providing an integrated circuit element with input/output pads;
providing a soldering metal;
bringing together said composite bumps formed on said substrate input/output pads, said integrated circuit element input/output pads, and said soldering metal;
heating said soldering metal to a temperature about 30°C above the melting point of said soldering metal; and
cooling said soldering metal below the melting point of said soldering metal.

5. A method of forming a composite bump structure by joining of integrated circuit elements to the next level of integration or that level of integration to the following level for forming composite bumps comprising the steps of:
providing an integrated circuit element or a substrate with input/output pads;
forming a layer of photosensitive polymer on the surface of said integrated circuit element or substrate;
exposing and developing a pattern on said photosensitive polymer so as to leave photosensitive polymer directly over said input/output pads only;
forming a conductive metal layer over the surface of said integrated circuit element or substrate;
forming a first photoresist mask on said conductive metal layer directly over said input/output pads;
etching said conductive metal layer not protected by said first photoresist mask; and stripping said first photoresist mask.

6. The method of claim 1, further comprising:
forming a third photoresist mask on said integrated circuit element or substrate, after the second photoresist mask has been stripped, covering the entire integrated circuit element or substrate surface except the area directly over the input/output pads;
forming a layer of soldering metal on said third photoresist mask and said composite bumps; and
stripping said third photoresist mask thereby leaving soldering metal only on the composite bumps.

7. The method of claim 5, further comprising:
forming a second photoresist mask on said integrated circuit element or substrate, after the first photoresist mask has been stripped, covering the entire integrated circuit element or substrate surface except the area directly over the input/output pads;
forming a layer of soldering metal on said second photoresist mask and said composite bumps; and
stripping said second photoresist mask thereby leaving only the soldering metal on the composite bumps.

8. The method of claim 2, further comprising:
forming a second photoresist mask on said integrated circuit element or substrate by lithography, after the first photoresist mask has been stripped, covering the entire integrated circuit element or substrate surface except the area directly over the input/output pads;
forming a layer of soldering metal on said second photoresist mask and said composite bumps; and
stripping said second photoresist mask thereby leaving only the soldering metal on the composite bumps.

9. The method of claim 2 wherein said vapor deposition polymerization comprises:
providing a vacuum of about 3.75 X 10-5 Torr;
spraying 4,4 Oxy-Dianiline onto said integrated circuit element or substrate;
heating said integrated circuit element or substrate to between about 80°C and 160°C;
spraying pyromellitic dianhydride onto said integrated circuit element or substrate; and
heating said integrated circuit element or substrate to between about 130°C and 180°C.

10. The method of claims 3 or 4 wherein said conductive metal coating is a composite of 500 Angstroms chrome/500 Angstroms copper/2000 Angstroms gold.

11. The method of claims 3 or 4 wherein said soldering metal is formed on said composite bumps prior to heating said soldering metal.

12. The method of claims 3 or 4 wherein said soldering metal is formed on said substrate input/output pads prior to heating said soldering metal.

13. The method of claim 4 wherein said soldering metal is applied on the IC substrate input/output pads prior to heating said soldering metal.

14. The method of claims 3, 4, 6 or 7 wherein said soldering metal is 95% lead and 5% tin.
